# EUROPEAN PATENT APPLICATION

(11) **EP 0 923 129 A1**
(43) Date of publication of application: **16.06.1999**
(21) Application number: 97121865.6
(22) Date of filing: 11.12.1997
(51) Int. Cl.: H01L 23/495

(54) **A lead frame for electronic semi-conductor devices**

(71) Applicant: SIEMENS AKTIENGESELLSCHAFT, 80333 München (DE)
(72) Inventor: Wan, Sharon Ko Mei, Paya Rumput, 76450 Melaka (MY); Khim, Alan Gan Chin, Ujong Pasir, 75050 Melaka (MY); Chin, Tan Sian, Semabok, 75050 Melaka (MY); Rahmat, Kartina Johan, Taman Peringgit Jaya Melaka (MY); Sian, Lim Wei, 75200 Melaka (MY)

(57) **Abstract**

A lead frame (5) for electronic semi-conductor devices includes a continuous strip of material and a number of mounting surfaces (6) connected to the continuous strip by a connecting portion (7). Each connecting portion (7) defines an aperture (2) and each connecting portion (7) is attached to the respective mounting surface (6) by a single section of material (8).

## Description

The invention relates to lead frames for electronic semi-conductor devices, and in particular, surface mounted devices.

During the assembly of electronic semi-conductor devices, it is common for dies, which are individual electronic circuits on a silicon wafer, to be mounted on a mounting surface (or stage) located on a metal frame known as a lead frame. Generally, the lead frame has a number of mounting surfaces. The lead frame is used for handling the dies during assembly and up to the singulation and lead forming stage. The lead frame includes an indexing hole associated with each device. The indexing hole is required during the initial assembly stages to enable alignment of the lead frame during the assembly processes prior to singulation.

However, with surface mounted devices there is the problem that the indexing hole must be removed during or after singulation. This removal of the indexing hole can result in mechanical stress in the device which can result in micro cracks in the device.

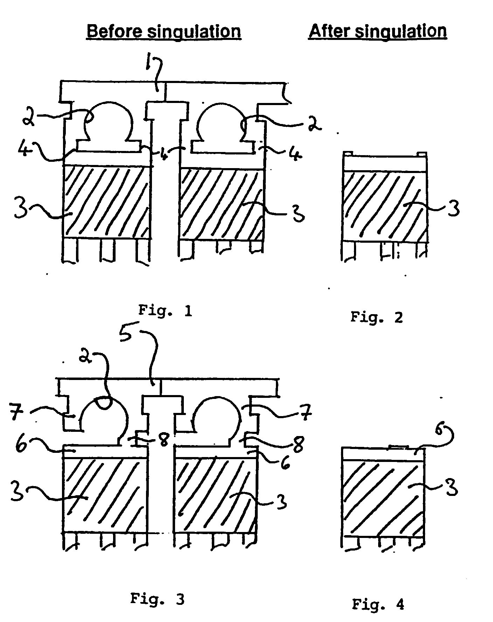

A conventional indexing hole and lead frame arrangement is shown in Fig. 1. In this prior art example, a lead frame 1 has a number of indexing holes 2. Each indexing hole 2 is associated with a respective electronic semi-conductor device 3. The lead frame 1 includes two leg portions 4 which connect the portion of the lead frame 1 defining the indexing hole 2 to a mounting surface 6 to which the device 3 is bonded. Accordingly, it is necessary to cut both leg portions 4 in order to remove the indexing hole 2, as shown in Fig. 2.

Hence, it is necessary to perform two cutting operations in order to remove the indexing hole 2.

In accordance with the present invention, a lead frame for electronic semi-conductor devices comprises a continuous strip of material, a number of mounting surfaces connected to the continuous strip by a connecting portion, each connecting portion defining an aperture therein, and each connecting portion being attached to a respective mounting surface by a single section of material.

An advantage of the invention is that by connecting the indexing hole to the mounting surface by a single section of material, only one cutting operation is require to remove each indexing hole and this reduces the mechanical stresses in the device during the cutting operation.

Preferably, the single section of material attaching the connecting portion to the mounting surface is positioned substantially centrally on an edge of the mounting surface.

Typically, where the single section of material is positioned substantially centrally with respect to the adjacent edges of the connecting portion and the mounting surface, the connecting portion is substantially symmetrical about an axis defined by a diameter of the aperture.

Typically, adjacent edges of the connecting portion and the mounting surface define a gap between the connecting portion and the mounting surface.

Preferably, the gap is generally 'V'-shaped and the single section of material is at the apex of the 'V'.

Typically, the adjacent edges define two gaps, one gap on either side of the section of material attaching the connecting portion to the mounting surface.

An example of a lead frame in accordance with the invention will now be described with reference to the accompanying drawings, in which:
Fig. 1 shows a conventional lead frame;
Fig. 2 shows the lead frame of Fig. 1 after singulation;
Fig. 3 shows a first example of a lead frame having a mounting surface attached by a single section of material;
Fig. 4 shows the lead frame of Fig. 3 after singulation;
Fig. 5 shows a second example of a lead frame having a mounting surface attached by a single section of material;
Fig. 6 shows the lead frame of Fig. 5 after singulation;
Fig. 7 shows a third example of a lead frame having a mounting surface attached by a single section of material; and,
Fig. 8 shows the lead frame of Fig. 7 after singulation.

Fig. 3 shows a lead frame 5 which has an electronic device 3 mounted on a mounting surface 6. The mounting surface 6 forms part of the lead frame 5 and is attached to an indexing hole portion 7 by a single section of material 8. The indexing hole portion 7 defines an indexing hole 2 which is used to align the lead frame at specific stages in the assembly process prior to singulation.

At singulation, the section 8 is cut to remove the portion 7 defining the indexing hole 2. Hence, after singulation, the indexing hole 2 and the portion 7 have been removed from the mounting surface 6 to leave the mounting surface 6 and the electronic device 3 mounted on the surface 6, as shown in Fig. 4. After singulation, and in use, the mounting surface 6 functions as a heat sink for the device 3.

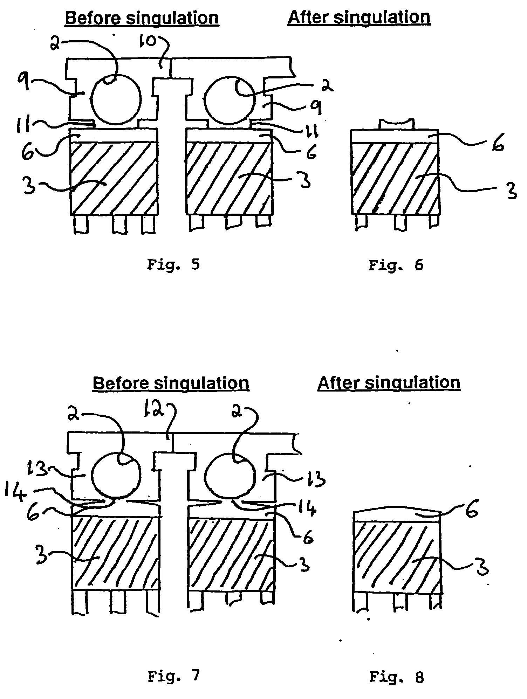

Alternative designs of indexing hole portions and arrangements for attaching the mounting surface 6 to the indexing hole portion are shown in Figs. 5 to 8.

In Fig. 5, the indexing hole 2 is defined by a portion 9 in a lead frame 10. The portion 9 is connected to the mounting surface 6 by a central joining section 11.

During singulation, portion 9 is removed by cutting through the joining section 11 to leave the device 3 and the mounting surface 6, as shown in Fig. 6.

Fig. 7 shows a third example of a lead frame 12 which includes a portion 13 which defines the indexing hole 2. The portion 13 is attached to the mounting surface 6 by a central joining section 14.

During singulation, the indexing hole 2 and portion 13 are removed by cutting through the section 14 to leave the mounting surface 6 and electronic device 3 as shown in Fig. 8.

The invention has the advantage of reducing the stress during singulation by reducing the material joining the mounting surface 6 to the indexing hole portion to a single section. Hence, in order to separate the mounting surface 6 from the portion defining indexing hole 2 it is only necessary to perform the cutting operation at one position/location, as opposed to performing this operation at two positions/locations for the conventional lead frame shown in Fig. 1.

In addition, by moving the joining section, which attaches the portion defining the indexing hole 2 to the mounting surface 6, to an approximately central location on an edge of the mounting surface 6 has the advantage of reducing stress during the singulation operation.

## Claims

1. A lead frame for electronic semi-conductor devices comprising a continuous strip of material, a number of mounting surfaces connected to the continuous strip by a connecting portion, each connecting portion defining an aperture therein, and each connecting portion being attached to the respective mounting surface by a single section of material.

2. A lead frame according to Claim 1, wherein the single section of material attaching the connecting portion to the mounting surface is positioned substantially centrally on an edge of the mounting surface.

3. A lead frame according to Claim 2, wherein the aperture is substantially circular and the connecting portion is substantially symmetrical about an axis defined by a diameter of the aperture.

4. A lead frame according to any of the preceding claims, wherein adjacent edges of the connecting portion and the mounting surface define a gap between the connecting portion and the mounting surface.

5. A lead frame according to Claim 4, wherein the gap is generally 'V'-shaped and the single section of material is at the apex of the 'V'.

6. A lead frame according to Claim 4 or Claim 5, wherein the adjacent edges define two gaps, one gap on either side of the section of material attaching the connecting portion to the mounting surface.

7. A lead frame according to any of the preceding Claims, wherein the mounting surface acts as a heatsink for a semi-conductor device mounted on the mounting surface, in use.
